Europäisches Patentamt

European Patent Office

Office européen des brevets

(19)

(11) EP 1 253 628 A1

(12) EUROPEAN PATENT APPLICATION
published in accordance with Art. 158(3) EPC

(43) Date of publication:
30.10.2002 Bulletin 2002/44

(51) Int Cl.⁷: H01L 21/02

(21) Application number: 01978854.6

(86) International application number:
PCT/JP01/09269

(22) Date of filing: 23.10.2001

(87) International publication number:
WO 02/035587 (02.05.2002 Gazette 2002/18)

(84) Designated Contracting States:
DE FR GB

(30) Priority: 23.10.2000 JP 2000323215
29.08.2001 JP 2001259174

(71) Applicant: Sony Corporation
Tokyo 141-0001 (JP)

(72) Inventors:
• HIRAI, Toshiya, c/o SONY CORPORATION
Tokyo 141-0001 (JP)
• YOKOO, Noboru,
c/o SONY SEMICONDUCTOR KYUSHU CORP.
Isahaya-shi, Nagasaki 854-0065 (JP)

• MAKITA, Masahiro, c/o SONY CORPORATION
Tokyo 141-0001 (JP)
• HAYAKAWA, Hideaki, c/o SONY CORPORATION
Tokyo 141-0001 (JP)
• YAMAMICHI, Yasuaki,
c/o SONY SEMICOND. KYUSHUCORP
Isahay-shi, Nagasaki 854-0065 (JP)
• SAKAMOTO, Akihisa,
c/o SONY SEMICOND. KYUSHU CORP.
Isahaya-shi, Nagasaki 854-0065 (JP)

(74) Representative: Müller, Frithjof E., Dipl.-Ing.
Müller Hoffmann & Partner
Patentanwälte
Innere Wiener Strasse 17
81667 München (DE)

(54) **METHOD OF PRODUCING SEMICONDUCTOR DEVICE AND PROCESSING CONDITIONS SETTING DEVICE**

(57) Provided is a method of manufacturing a semiconductor device in which various kinds of processing conditions such as the polishing time in a CMP step can be always provided most appropriate against a wafer of a product lot even if there is an error in the film thickness or the like generated in a CVD step performed prior to the CMP step. The processing conditions in the CMP step are provided based on the film thickness formed in the prior CVD step. Thereby, even if there is an error in the film thickness generated in the CVD step, the processing conditions in the CMP step are provided most appropriate with the consideration of the error. In detail, based on the CVD film thickness and the target value, a processing condition calculator performs calculation of the actual amount of polishing of the present lot. Then, the processing condition calculator performs calculation based on the data, and the searched polishing rate or the searched updated value. Thereby, the polishing time is calculated.

FIG. 4

Printed by Jouve, 75001 PARIS (FR)

## Description

### TECHNICAL FIELD

The invention relates to a method of manufacturing a semiconductor device comprising steps of performing a plurality of different kinds of processing on a wafer, and an apparatus for providing a processing condition used in the steps of manufacturing a semiconductor device to which the manufacturing method is applied.

### BACKGROUND ART

In the manufacturing process of a semiconductor device comprising steps of performing a plurality of different kinds of processing on a wafer, for example, one of the main processing conditions in a CMP (Chemical Mechanical Polishing) process such as the polishing time is generally determined as follows. So-called a pilot wafer is used for performing a test polishing as a prototype or an experiment. The practical polishing time in the manufacturing steps of the product lot is determined based on the result.

However, the manufacturing steps require a longer time at least for performing such test polishing. Therefore, it is inevitable for the throughput to be deteriorated.

Although the most appropriate processing condition is employed in performing a CMP step itself, in the actual manufacturing process of the product lot, there are cases where there is a large difference in the film thickness obtained by polishing by a CMP step on a film formed on a wafer by, for example, a CVD (Chemical Vapor Deposition) step.

In general, a bare wafer is used as the pilot wafer used in a test polishing. However, when actually performing a CMP step on a wafer of the product lot, asperities are formed on the surface of the wafer which contributes to errors. As a result, the most appropriate polishing time verified by the test polishing is not necessarily the most appropriate for the actual product lot. Therefore, there may be a case where the yield of the product lot is deteriorated.

Thereby, it is considered effective to estimate the most appropriate polishing time based on the correlation between the film thickness of a wafer and the polishing time by measuring the film thickness after polishing the wafer by the CMP step using not a bare wafer as a pilot wafer but a wafer on which the same patterns as those on a wafer of the actual product lot are formed. However, there may be cases where there are differences in the film thickness after polishing due to the differences in the film thickness generated in the CVD step, even though the CMP step is performed for the polishing time which is estimated as the most appropriate by further complicating the test polishing as described so as to be more like the method of manufacturing the actual product lot.

Also, in addition to the CMP step as described, there may be cases where there are the same differences as described in the results of the processing in, for example, a dry-etching step of forming a wiring pattern and a photolithography step of forming a resist pattern.

The invention has been designed to overcome the foregoing problems. An object of the invention is to provide a method of manufacturing a semiconductor device in which various kinds of processing conditions such as the polishing time in the CMP step in the manufacturing steps of a semiconductor device can be always provided most appropriate for a wafer of the product lot without performing a test using a pilot wafer, and an apparatus for providing a processing condition used in the manufacturing steps of a semiconductor device to which the manufacturing method is applied.

### DISCLOSUR OF THE INVENTION

A method of manufacturing a semiconductor device of the invention comprises a plurality of steps for performing different processing on a wafer, wherein a processing condition in a predetermined step among the plurality of the steps is provided based on the result of processing performed in a former step where different processing is performed.

Another method of manufacturing a semiconductor device of the invention comprises a plurality of steps for performing different processing on a wafer, wherein a processing condition in a predetermined step among the plurality of steps is provided based on a processing condition in a former step where different processing is performed.

An apparatus for providing a processing condition of the invention is used in a method of manufacturing a semiconductor device comprising a plurality of steps for performing different processing on a wafer. The apparatus comprises means for providing a processing condition in a predetermined step among the plurality of steps based on the result of processing performed in a former step where different processing is performed.

Another apparatus for providing a processing condition of the invention is used in a method of manufacturing a semiconductor device comprising a plurality of steps for performing different processing on a wafer. The apparatus comprises means for providing a processing condition in a predetermined step among the plurality of steps based on a processing condition in a former step where different processing is performed.

In a method of manufacturing a semiconductor device of the invention, a processing condition in a predetermined step is provided based on the result of processing performed in a former step where different processing is performed. Thereby, even if there is an error generated in the processing performed in the former step of the predetermined step, the processing condition in the predetermined step can be provided most appropriate with the consideration of the error.

Also, an apparatus for providing a processing condition of the invention comprises means for providing a processing condition in a predetermined step based on the result of processing performed in a former step where different processing is performed, thereby performing an operation for providing a processing condition in a method of manufacturing a semiconductor device as described.

Other and further objects, features and advantages of the invention will appear more fully from the following description.

BRIEF DESCRIPTION OF THE DRAWINGS

Figs. 1A and 1B are cross sections of a wafer showing an example of a case where there is an error in the film thickness generated in a CVD step.

Figs. 2A to 2D are cross sections of a wafer showing an example of a case where there is an error in the film thickness generated after polishing by a CMP step when there is an error in the film thickness having already generated in the CVD step.

Fig. 3 is a flow chart of the main steps in a method of manufacturing a semiconductor device according to an embodiment of the invention.

Fig. 4 is a flow chart of the main steps following the steps shown in Fig. 3.

Fig. 5 is a block diagram showing the main configuration of an apparatus for providing a processing condition used to provide a processing condition.

Figs. 6A to 6C are figures for showing an example of a case where there is an error in a photolithography step and a dry-etching step.

BEST MODE FOR CARRYING OUT THE INVENTION

In the followings, an embodiment of the invention will be described in detail by referring to the drawings.

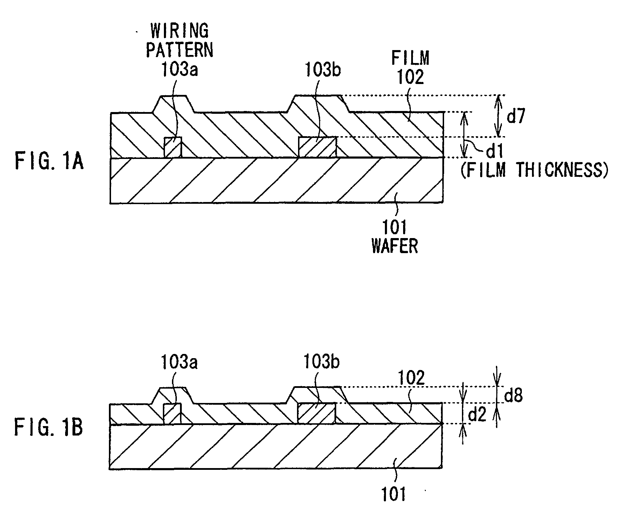

Figs. 1A and 1B show cross sections of a wafer as an example of a case where there is an error generated in the film thickness in a CVD step for forming a film. A film 102 and a wiring patterns 103a and 103b are formed on a wafer 101 by a CVD step using a CVD film-forming apparatus. The film 102 is formed thicker than the heights of the wiring patterns 103a and 103b so as to cover the wiring patterns 103a and 103b.

A thickness d2 of the film 102 formed on the wafer 101 shown in Fig. 1B is thinner than a thickness d1 of the film 102 formed on the wafer 101 shown in Fig. 1A. The difference is generated mainly due to exhaustion of the target material during the continuing processing of film-forming, even if the processing conditions of the CVD apparatus such as film-forming time and the concentration of gas are provided most appropriate at the time of starting the processing. The changes in the film thickness are errors generated because of the changes in the thickness of the film 102 after being formed, even if the films are formed in the same film-forming time. Therefore, it is extremely difficult to completely resolve the changes in the film thickness as described.

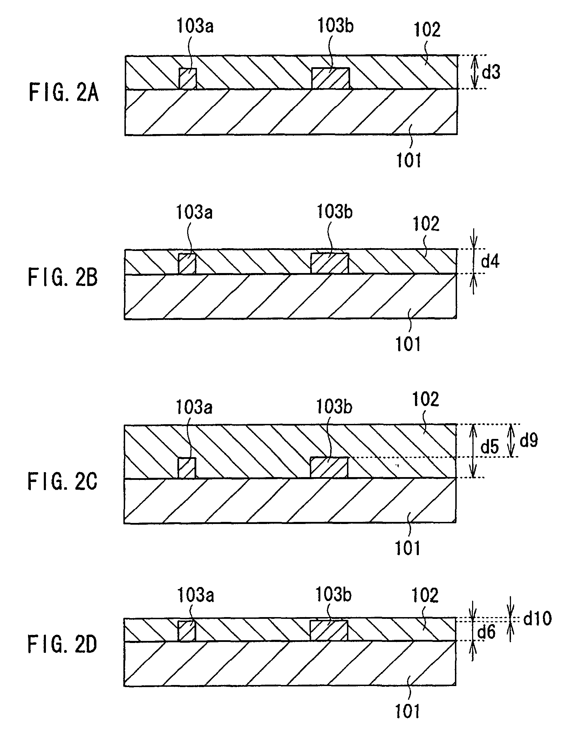

When such changes in the film thickness are generated in the CVD step, even if polishing is performed on the wafer 101 shown in Fig. 1A and the wafer 101 shown in Fig. 1B under the perfectly same processing condition in the CMP step, the film thickness after polishing becomes different (for example, a film thickness d4 shown in Fig. 2B becomes thinner than a film thickness d3 shown in Fig. 2A).

If the CMP step is continuously performed on a plurality of the wafers 101 or a plurality of the product lots, it is difficult to avoid exhaustion of an abrasive pad and abrasive agent. Therefore, errors in the film thickness are generated by the CMP step itself by every wafer 101 or every product lot. As a result, for example, the film may become thicker such as a film thickness d5 as shown in Fig. 2C. Inversely, as shown in Fig. 2D, the film may become thinner such as a film thickness d6 so that the wiring patterns 103a and 103b may also be removed. In other words, in the case where the amount of polishing is to be the same by performing the CMP step under the same processing conditions, when a thick film such as the film thickness d1 shown in Fig. 1A is formed in the CVD step, the film becomes thick such as the film thickness d3 as shown in Fig. 2A after being polished by the CMP step. On the contrary, when a thin film such as the film thickness d2 shown in Fig. 1B is formed in the CVD step, the film becomes thin such as the film thickness d4 as shown in Fig. 2B after being polished by the CMP step. Also, when the amount of polishing is provided to be less than the amounts in the cases shown in Figs. 2A and 2B, or when the film further thicker than the film thickness d1 shown in Fig. 1A is formed in the CVD step, the film thickness after being polished becomes further thicker such as the film thickness d5 as shown in Fig. 2C. Inversely, when the amount of polishing is provided to be more than the amounts in the cases shown in Figs. 2A and 2B, or when the film further thinner than the film thickness d2 shown in Fig. 1B is formed in the CVD step, the film thickness after being polished becomes further thinner such as the film thickness d6 as shown in Fig. 2D. In this case, there may be cases where the wiring patterns 103a and 103b are also removed, which are not as designed. It is needless to mention that the correlation of the film thicknesses shown in Figs. 1A, 1B and Figs. 2A to 2D are d5>d1>d3>d2>d4>d6.

In an ordinary manufacturing method, the factors mentioned above may add up, thereby causing a large error in the film thickness after polishing by the CMP step. Therefore, in general, in a method of manufacturing a semiconductor device, the polishing rate in the CMP step is corrected by every wafers 101 or every product lot based on data such as the average of the shift in the correlation between the actual polishing time and the amount of polishing during the period when an abrasive pad is used.

It is needless to say such method, where the processing conditions of the CMP step itself is measured and the polishing rate is corrected based on the data, can be used in the manufacturing method according to the embodiment. However, by simply using such ordinary method of correcting the processing conditions, it is difficult to suppress the change in the film thickness fully effectively after performing polishing by the CMP step.

Therefore, in the manufacturing method according to the embodiment, the following manner is employed so that the film formed by the CVD step and the like can be always polished to be in a precise film thickness by the CMP step by suppressing the changes in the film thickness after polishing by the CMP step due to the changes in the film thickness generated in the CVD step and the changes in the polishing rate generated in the CMP step. The thickness of the film formed in the CVD step prior to the CMP step is measured, the difference between the data and the target value of the film thickness according to the design is obtained, the value is divided by the target value and the above-mentioned polishing rate is updated, thereby to provide various processing conditions such as the polishing time in the CMP step and the intensity of pressure at the time of polishing.

Also, for example, data such as the accumulated time of using the target member and other film-forming conditions of the CVD film-forming apparatus can be transmitted to the CMP apparatus instead of using data of the film thickness formed by the CVD step. Based on the data, it is possible to provide the various processing conditions of polishing by the CMP apparatus.

When a plurality of product lots are continuously processed by one CMP apparatus, the maintenance of the hardware of the CMP apparatus itself is performed in every specific period. When the maintenance is performed, the changes in the polishing rate before and after the maintenance becomes intermittent. Therefore, it is necessary to fundamentally re-provide the processing conditions. For example, in a CMP step of a wafer in a product lot, there is 10 % change in the film thickness in average and 31 % change at most. This indicates, for example, there is 434 nm error generated when the polishing amount of 1400 nm is removed from a silicon oxide film. On the contrary, when a number of wafers in a plurality of lots are processed continuously after the maintenance, there is 15 % change generated at most. This indicates there is 2109 nm error generated when the polishing amount of 1400 nm is removed from a silicon oxide film.

In the case were such maintenance is performed, the changes in the film thickness after polishing by the CMP step can be suppressed and the film thickness obtained after the processing can always be made precise by providing various conditions of polishing performed on the wafers and the product lots after the maintenance based on data such as thickness of the film formed on the wafer right after the maintenance and the amount of polishing.

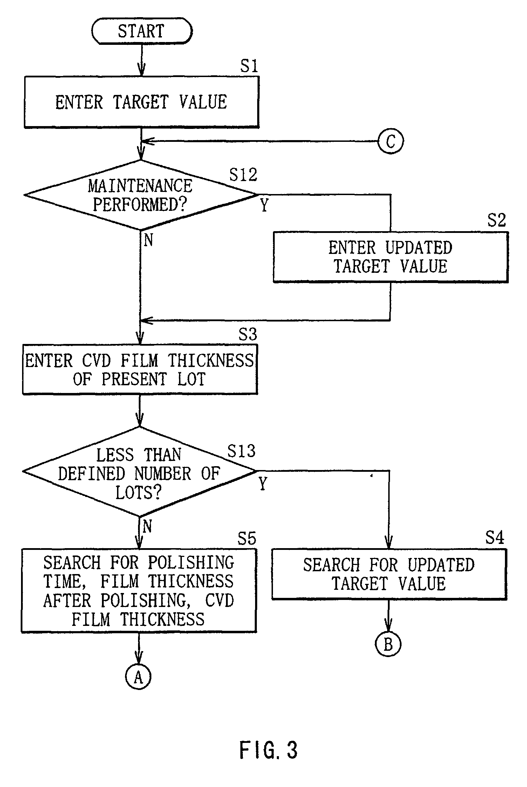

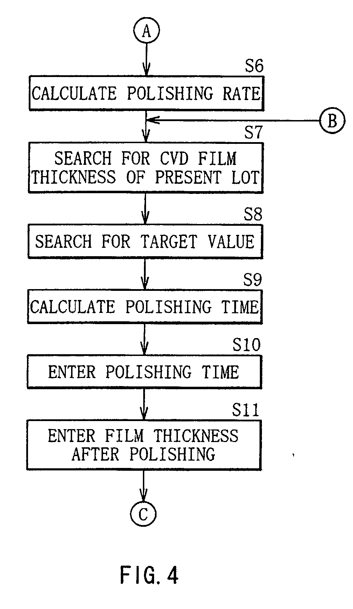

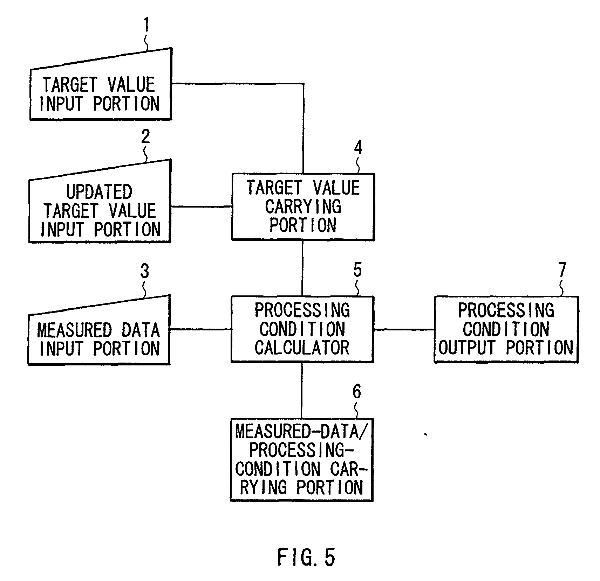

Next, the outline of the step of processing a wafer to which a method of manufacturing a semiconductor device according to the embodiment is applied will be described further in detail. Also, the configuration of the main parts of an apparatus for providing a processing condition used in the manufacturing method will be described. Fig. 3 and Fig. 4 are flow charts showing the main parts in the manufacturing method. Fig. 5 is a block diagram which shows the main parts of the apparatus for providing a processing condition used for providing the processing conditions.

The apparatus for providing a processing condition comprises a target value input portion 1, an updated target value input portion 2, a measured data input portion 3, a target value carrying portion 4, a processing condition calculator 5, a measured-data/processing-condition carrying portion 6, and a processing condition output portion 7.

The target value input portion 1 is used for inputting the target value data by, for example, a manual operation. The target value is data such as the film thickness of the film to be formed and the depth of polishing provided based on the conditions according to the design before performing a film-forming step and a polishing step on a wafer in the processing step.

The updated target value input portion 2 is for, when maintenance is performed on a CVD film-forming apparatus and a CMP apparatus, inputting data of a new target value obtained by measuring the wafer processed right after the maintenance or the wafer tentatively processed for a processing condition test.

The target value carrying portion 4 is for recording (storing) data of the target value so as to be in a state where data of the target value can be read-out/recorded at any time.

The measured data input portion 3 is for measuring the value of the film thickness in the present lot formed in the CVD step, and for inputting the data to the processing condition calculator 5. The input operation of data may be manually performed by a user or the data may be automatically inputted when the value of the film thickness is measured.

The processing condition output portion 7 is for inputting a request to the processing condition calculator 5 to perform calculation of processing conditions, and for outputting the information of the calculation result of the processing conditions.

Upon receiving the request for calculation of the processing conditions from the processing condition output portion 7, the processing condition calculator 5 searches and outputs each data recorded in the measured-data/processing-condition carrying portion 6 such as the CVD film-thickness value, the film-thickness value after polishing, and the polishing time. Based on the above-mentioned data and data of the CVD film-thickness value in a subject wafer to which polishing is to be performed, the polishing rate is calculated. The polishing rate obtained by calculation is transmitted to the processing condition output portion 7.

The measured-data/processing-condition carrying portion 6 is for storing each data such as the CVD film-thickness value of the lot which has already been processed, the film thickness value after polishing, and polishing time in a state where the data can be read-out/recorded at any time.

Before performing a film-forming step or a polishing step of a wafer in the processing step, the target value of film thickness of a film to be formed and the target value of the depth of polishing are provided as initial values based on the conditions according to the design. The data is inputted from the target value input portion 1. The data is recorded on the target value carrying portion 4 (S1).

In the case where the maintenance is performed on the CVD film-forming apparatus or the CMP apparatus (S12-Y), data of a new target value obtained by measuring a wafer processed right after the maintenance or a wafer tentatively processed for processing condition test is inputted from the updated target value input portion 2. The data is recorded on the target value carrying portion 4 (S2).

The wafer of the present lot is provided in the processing step thereby to perform the CVD step of forming a film and polishing by the CMP step. First, the value of the film thickness of the present lot (CVD film thickness value) formed in the CVD step is measured and the data is inputted from the measured data input portion 3. The data is recorded on the measured-data/processing-condition carrying portion 6 via the processing condition calculator 5 (S3).

In the case where the number of lots processed within the period from the maintenance to the ongoing step is smaller than a defined number of lots, (S13-Y), data of the updated target value which has already been recorded is searched from the target value carrying portion 4 (S4). The data is employed as the polishing rate of the CMP step of the product lot under ongoing processing.

In the case where the number of lots which have been processed is the defined number of lots or larger (S13-N), each data such as the CVD film thickness value, the film thickness value after polishing, and the polishing time, which is measured within the period from the previous maintenance to the ongoing processing of the product lots and is recorded on the measured data/processing condition carrying portion 6, is searched (S5). Based on the data, the processing condition calculator 5 calculates the processing conditions such as polishing rate in the CMP step (S6). The calculation method of the polishing rate performed at this time is, for example, as follows.

The difference between the CVD film thickness value obtained in the step performed prior to the CMP step to be performed and the film thickness value after polishing is divided by the polishing time provided at this point. This calculation is performed on every lot and the sum of all the values obtained by the calculation is calculated. The average value is obtained by dividing the sum of all the values by the number of lots. Thereby, the polishing rate in the CMP step to be performed is obtained. The calculation process can be expressed by the following calculation formula:

$$Ra = \square\,((T_{di} - T_{pi}) / T_{mi}) / L \qquad\qquad \text{Calculation Formula 1}$$

where, Ra is the polishing rate, $T_{di}$ is the CVD film thickness, $T_{pi}$ is the film thickness after polishing, $T_{mi}$ is the polishing time, and L is the number of lots.

After obtaining the polishing rate, the CVD film thickness of the present lot measured and recorded in S3 is searched (S7) and the target value inputted and recorded in S1 is searched (S8).

Based on the searched CVD film thickness value and the target value, the processing condition calculator 5 calculates the amount of polishing of the present lot. The polishing time is obtained (S9) by performing calculation based on the calculated data, the polishing rate searched in S4, and the updated target value (updated polishing rate) searched in S6. In detail, the actual amount of polishing of the present lot is obtained by calculating the difference between the CVD film thickness of the present lot and the target value of the film thickness after polishing according to the design. Then, the actual amount of polishing is divided by the polishing rate which is obtained by reflecting the present state of the apparatus such as the degree of wear of the abrasive pad. Thereby, the actual polishing time can be calculated.

The calculation process can be expressed, for example, by the following calculation formula:

$$Tm = ( Td - T) / Ra \qquad \text{Calculation Formula 2}$$

where, Tm is the polishing time, Td is the CVD film thickness, T is the target value, and Ra is the polishing rate.

Based on the data of the polishing time calculated as described, the polishing time in the CMP step is provided, and polishing is performed according to the polishing time. Also, the data of the polishing time is recorded on the measured-data/processing-condition carrying portion 6 (S10).

When the polishing is completed, the film thickness after polishing is measured. The data is recorded on the measured-data/processing-condition carrying portion 6 as the film thickness after polishing (S11).

As described, the thickness of the film formed in the CVD film-forming step performed prior to the CMP step is measured. Based on the data of the CVD film thickness, the processing conditions such as the polishing time in the CMP step are provided. Thereby, changes in the film thickness after polishing in the CMP step which is generated due to the changes in the CVD film thickness can be suppressed. Therefore, polishing can be performed to be always in the precise film thickness in the CMP step even if there is an error or the like in the film formed in the CVD step or the like.

Further, the invention is also applicable in cases other than the case of providing the processing conditions such as the polishing time and the like in the CMP step. For example, in a manufacturing process comprising a photolithography step of transferring a chip pattern on a resist on a wafer and a dry-etching step of forming the chip pattern on the wafer based on the resist pattern, the processing conditions such as the etching time and the like in the dry-etching step can be provided based on information such as the processing conditions in the photolithography step prior to the dry-etching step, the differences between the line width of the resist pattern patterned by the photolithography, or the film thickness of the resist itself. Thereby, precise patterning can be always performed in the dry-etching step even if there is an error generated in the photolithography step.

In addition, in a manufacturing process comprising a step of forming a film on a wafer by the CVD step and a photolithography step of transferring a predetermined pattern on the film, the processing conditions such as the exposure time in the photolithography step can be provided based on information such as the processing conditions in the step of forming the film in the CVD step, the measured value of the thickness of the film formed in the CVD step, or the differences of the film thickness. Thereby, it is also possible to always perform precise transferring and forming of the pattern even if there is an error in the film thickness generated in the CVD step.

Furthermore, in two different steps of the same kinds of processing, it is also possible to reflect information of the result of processing performed in the prior step and the processing condition to provide the processing conditions in the step performed thereafter. For example, based on the information such as the processing conditions in a first photolithography step for forming a layer among a plurality of layers composing a semiconductor chip pattern, the measured values of the line width of the resist pattern and chip pattern formed by the photolithography, or the errors and differences generated therein, the processing conditions such as the exposure time in a second photolithography step performed for forming another layer is provided after the first photolithography.

[First Example]

In the case of a method of manufacturing a semiconductor device as described and the case of an ordinary method of manufacturing a semiconductor device of the related art, a film was formed each on a wafer of an actual product lot by the CVD step. Then, polishing was performed on the wafers by the CMP step and the errors and differences in the line widths of the formed patterns were measured.

First, a film was formed and polished by an ordinary method of manufacturing a semiconductor device of the related art. As a result, in the wafer on which a thick film as shown in Fig. 1A was formed by the CVD step, the film thickness after polishing by the CMP step became thick as shown in Fig. 2C, which was out of the permissible range of the film thickness after polishing. In a multi-layer wiring step, the measuring points of the interlayer insulating film changed to d7 in Fig. 1A. Therefore, in the wafer on which a thick film as shown in Fig. 1A was formed, the film thickness after polishing became pronouncedly thick as d9 shown in Fig. 2C, which was out of the permissible range of the film thickness after polishing. In detail, the film thickness d1 of the film formed in the CVD step became 1070 nm and the film thickness d3 after polishing the film became 665 nm. The permissible range (control spec.) of the film thickness of a film formed in the CVD step was defined to be from 880 nm to 1080 nm (980!100 nm). Also, the permissible range of the film thickness after polishing by the CMP step was defined to be from 492 nm to 652 nm (572!80 nm). Therefore, the film thickness d1 of 1070 nm, which was the thickness of the film formed by the CVD at that time fell within the range. However, the error against the target value of 980 nm was +90 nm, which was quite large. There was also the error generated in the polishing by the CMP step in addition to the large error already being generated in the CVD step. Thereby, the film thickness d3 after polishing became 665 nm, which was thicker than the maximum value of the permissible range of 652 nm.

Also, in a wafer on which a rather thin film, which was close to the target value as shown in Fig. 1B, was formed in the CVD step, the film thickness after polishing by the CMP step became thin as shown in Fig. 2D, which fell within the permissible range of the film thickness after polishing. In a metal step, the measuring points changed to d8 shown in Fig. 1B. Therefore, in the wafer on which the thin film as shown in Fig. 1B was formed, the film thickness after polishing became pronouncedly thin as d10 shown in Fig. 2D, which was out of the permissible range of the film thickness after polishing. In detail, the film thickness d2 formed in the CVD step became 971 nm, and the film thickness d4 after polishing became 537 nm. Therefore, both of the values fell within the permissible range. However, the error against the target value of the film thickness of 980 nm in the CVD step was -9 nm and the error against the target value of the film thickness of 572 nm in the CMP step was -35 nm.

On the other hand, a film was formed and polished by a method of manufacturing a semiconductor device according to the embodiment. As a result, the film thickness became 590 nm after polishing which was performed on a wafer on which a film with the film thickness d1 of 1070 nm, as in the case shown in Fig. 1A, was formed in the CVD step. The error against the target value became 18 nm. Thereby, the error was remarkably reduced and it was verified that the value fell within the permissible range of the film thickness after polishing. Also, in a wafer on which a rather thin film with the film thickness d3 of 971 nm, close to the target value as shown in Fig. 1B, was formed in the CVD step, the film thickness after polishing by the CMP step became 565 nm and the error against the target value at this time was -7 nm. Therefore, it was verified that the error was further reduced.

As described, in the manufacturing method according to the embodiment, the most appropriate processing conditions in the CMP step can be provided even if there is an error generated in the film thickness by the CVD step, and the film thickness obtained after the polishing can be always made within the permissible range.

[Second Example]

In the case of a method of manufacturing a semiconductor device as described and the case of an ordinary method of manufacturing a semiconductor device of the related art, a resist pattern was formed each on a wafer of an actual product lot by a photolithography step. Then, patterning was performed by the photolithography step and the errors and differences in the line width of the formed pattern were measured.

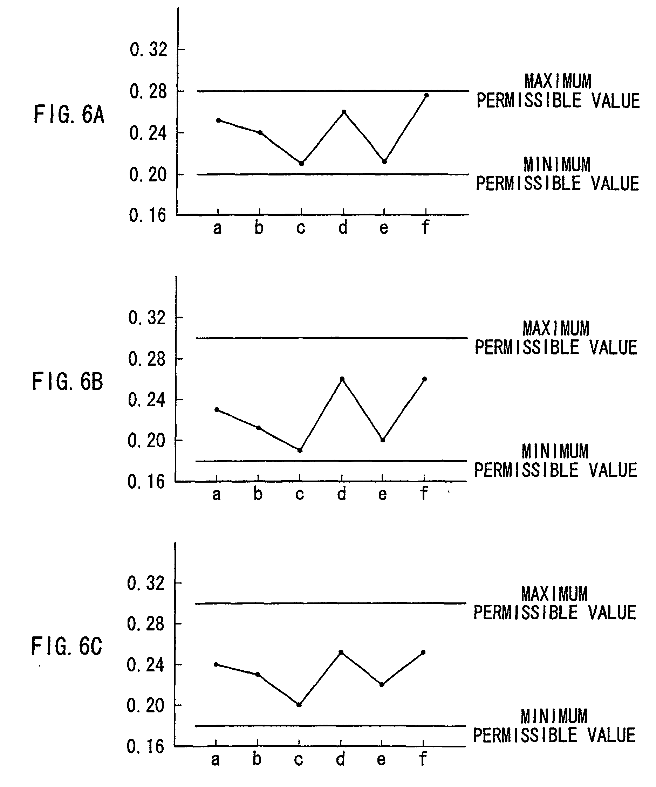

First, a film was formed and patterned by an ordinary method of manufacturing a semiconductor device of the related art. As a result, as shown in Fig. 6A, the average values of the line width of the resist pattern in each of lots a to f formed in the photolithography step was as follows; lot a = 0.25 μm, lot b = 0.24 m, lot c = 0.21 μm, lot d = 0.26 μm, lot e = 0.21 μm, lot f= 0.27 μm, distributing between 0.21 μm minimum and 0.27 μm maximum. Each of the lots fell within the range of 0.20 μm to 0.28 μm, which was defined as the permissible range for the quality control. The errors against the target value of 0.24 μm defined at that time were as follows; lot a = +0.01 μm, lot b = 0.00 μm, lot c = -0.03 μm, lot d = +0.02 μm, lot e = -0.03 μm, lot f= +0.03 μm.

On the wafer on which such resist pattern was formed, processing was performed by a dry-etching step under an ordinary condition. As a result, the processing condition itself of the dry-etching step was provided so that the pattern precision within the permissible range of the quality control could be achieved. Also, the permissible range was provided from 0.18 μm minimum to 0.30 μm maximum, which was wider than the permissible range of the line width in the photolithography step. However, there was a case where the difference between the line width of the completed pattern became large as the lot c shown in Fig. 6B being out of the permissible range.

In other words, the line width of each of the lot a to f was as follows; lot a = 0.23 μm, lot b = 0.21 μm, lot c = 0.17 μm, lot d = 0.26 μm, lot e = 0.20 μm, lot f = 0.26 μm. Although the values of the lots a, b, d, e, and f fell within the permissible range, the value of the lot c was about 0.01 μm thinner than the minimum value of the permissible range. Also, the errors against the target value of 0.24 μm were as follows; lot a = -0.01 μm, lot b = -0.03 μm, lot c = -0.07 μm, lot d = +0.02 μm, lot e = -0.04 μm, lot f = +0.02 μm. The maximum error generated was twice or more as large as the error of the line width of the resist pattern formed in the photolithography step.

In each step, the error was provided to fall within the permissible range. However, it is considered that the error generated in the resist pattern formed in the photolithography step together with the error generated in the dry-etching step caused the error out of the permissible range generated in the pattern obtained at last. For example, in the case of the lot c, there was an error of 0.21 μm average in the line width of the resist pattern. In addition, there was an error generated in the dry-etching step. Therefore, it is considered that an error of -0.07 μm was generated in the pattern obtained at last.

On the other hand, by a method of manufacturing a semiconductor device according to the above-mentioned embodiment, the line width of a resist pattern formed in the photolithography step prior to the dry etching step was measured. Based on the data of the measured value of the line width, the main processing conditions such as the etching time in the dry-etching step was provided. Then, patterning was performed on a wafer of the actual product lot, and the error and difference in the line width of the formed pattern was measured. The same hardware used in the ordinary steps of the related art mentioned above was also used, such as an exposure apparatus and developing apparatus used for performing the photolithography step, and a dry-etching apparatus. In regard to the resist pattern, two wafers were to be continuously processed in each lot in a photolithography step by an ordinary method of the related art mentioned above. One of the wafers in each lot was to be patterned by the dry-etching step by an ordinary method of the related art mentioned above and the other wafer was to be patterned by a dry-etching step according to the embodiment. Various kinds of processing conditions, except for the processing conditions provided by a method according to the embodiment, were provided to be the same as those in the ordinary manufacturing step of the related art as much as possible. Examples of the various kinds of processing conditions were the order of lots to be put in the manufacturing step, the number of wafers processed in each lot, the temperature and humidity of the atmosphere in which the step was performed, the materials of the wafer and resist, and the substances of the etching gas.

As a result, as shown in Fig. 6C, the average values of the line width of the pattern in each of the lots a to f obtained by performing a dry-etching step after the photolithography step was as follows; lot a = 0.24 μm, lot b = 0.23 μm, lot c = 0.20 μm, lot d = 0.25 μm, lot e = 0.22 μm, lot f = 0.25 μm. Each of the lots fell within the range of 0.18 μm to 0.30 μm, which was defined as the permissible range for the quality control. Also, the errors against the target value of 0.24 μm defined at that time were as follows; lot a = 0.00 μm, lot b = -0.01 μm, lot c = -0.04 μm, lot d = +0.01 μm, lot e = -0.02 μm, lot f = +0.01 μm. Thereby, it was verified that the error in each lot was remarkably reduced. Especially, in regard to the lot c, the error was effectively suppressed. The error in the lot c was -0.07 μm by the ordinary manufacturing method of the related art, which was out of the permissible range. The error became -0.04 μm, which was about half the value of the case using the manufacturing method of the related art.

As described, with the manufacturing method according to the embodiment, even if there is an error generated in the resist pattern in the photolithography step, the most appropriate processing conditions in the dry-etching step can be provided, and the line width of the pattern obtained by the dry-etching processing can be always made within the permissible range.

INDUSTRIAL APPLICABILITY

As described, in a method of manufacturing a semiconductor device and an apparatus for providing a processing condition of the invention, the processing condition in a predetermined step is provided based on the result of processing performed in the former step where different processing is performed. Thereby, even if there is an error generated in the processing performed in the former step of the predetermined step, the processing condition in the predetermined step can be provided most appropriate with the consideration of the error. Therefore, various kinds of processing conditions in a predetermined step in an method of manufacturing a semiconductor device can be always provided most appropriate even if there is an error or difference generated in the former step. Moreover, the yield of product lots can be further improved and no prior test using a pilot wafer or the like or only a minimum test becomes necessary.

Obviously many modifications and variations of the present invention are possible in the light of above teachings. It is therefore to be understood that within the scope of the appended claims the invention may be practiced other wise than as specifically described.

## Claims

1. A method of manufacturing a semiconductor device comprising a plurality of steps for performing different processing on a wafer, wherein
   a processing condition in a predetermined step among the plurality of steps is provided based on the result of processing performed in a former step where different processing is performed.

2. A method of manufacturing a semiconductor device as claimed in claim 1, wherein

   the predetermined step is a step of polishing a film formed on a wafer; and
   the former step is a step of forming the film on the wafer.

3. A method of manufacturing a semiconductor device as claimed in claim 1, wherein

   the predetermined step is a step of forming a pattern on a wafer based on a resist pattern formed on the wafer; and
   the former step is a step of forming the resist pattern on the wafer.

**4.** A method of manufacturing a semiconductor device as claimed in claim 1, wherein

the predetermined step is a step of patterning a film formed on a wafer; and
the former step is a step of forming the film on the wafer.

**5.** A method of manufacturing a semiconductor device as claimed in claim 1, wherein
in the case where there is a change in the processing condition of the predetermined step or in the former step, right after the change, a processing condition in the predetermined step is provided based on the result of processing performed.

**6.** A method of manufacturing a semiconductor device as claimed in claim 1, comprising a plurality of steps for performing different processing on a wafer, wherein
a processing condition in a predetermined step among the plurality of steps is provided based on a processing condition in a former step where different processing is performed.

**7.** An apparatus for providing a processing condition used in a method of manufacturing a semiconductor device comprising a plurality of steps for performing different processing on a wafer, wherein
the apparatus comprises means for providing a processing condition in a predetermined step among the plurality of steps based on the result of processing performed in a former step where different processing is performed.

**8.** An apparatus for providing a processing condition as claimed in claim 7, wherein

the predetermined step is a step of polishing a film formed on a wafer; and
the former step is a step of forming the film on the wafer.

**9.** An apparatus for providing a processing condition as claimed in claim 7, wherein

the predetermined step is a step of forming a pattern on a wafer based on a resist pattern formed on the wafer; and
the former step is a step of forming the resist pattern on the wafer.

**10.** An apparatus for providing a processing condition as claimed in claim 7, wherein

the predetermined step is a step of patterning a film formed on a wafer; and
the former step is a step of forming the film on the wafer.

**11.** An apparatus for providing a processing condition as claimed in claim 7, wherein
in the case where there is a change in the processing condition of the predetermined step or in the former step, right after the change, a processing condition in the predetermined step is provided based on the result of processing performed.

**12.** An apparatus for providing a processing condition used in a method of manufacturing a semiconductor device comprising a plurality of steps for performing different processing on a wafer, wherein
the apparatus comprises means for providing a processing condition in a predetermined step among the plurality of steps based on a processing condition in a former step where different processing is performed.

FIG. 1A

WIRING
PATTERN
103a      103b       FILM
102

d7

d1
(FILM THICKNESS)

101
WAFER

FIG. 1B

103a      103b       102

d8

d2

101

FIG. 2A

103a  103b  102

d3

101

FIG. 2B

103a  103b  102

d4

101

FIG. 2C

103a  103b  102

d5  d9

101

FIG. 2D

103a  103b  102

d6  d10

101

EP 1 253 628 A1

FIG. 3

12

```
                    ( A )
                      |
                      v                      S6
        +-------------------------------+
        | CALCULATE  POLISHING  RATE    |
        +-------------------------------+
                      |  <---------------------( B )
                      v                      S7
        +-------------------------------+
        |    SEARCH  FOR  CVD  FILM     |
        | THICKNESS  OF  PRESENT  LOT   |
        +-------------------------------+
                      |
                      v                      S8
        +-------------------------------+
        |   SEARCH  FOR  TARGET  VALUE  |
        +-------------------------------+
                      |
                      v                      S9
        +-------------------------------+
        | CALCULATE  POLISHING  TIME    |
        +-------------------------------+
                      |
                      v                      S10
        +-------------------------------+
        |    ENTER  POLISHING  TIME     |
        +-------------------------------+
                      |
                      v                      S11
        +-------------------------------+
        |   ENTER  FILM  THICKNESS      |
        |      AFTER  POLISHING         |
        +-------------------------------+
                      |
                      v
                    ( C )
```

FIG. 4

FIG. 5

FIG. 6A

FIG. 6B

FIG. 6C

## INTERNATIONAL SEARCH REPORT

| | International application No. |
|---|---|
| | PCT/JP01/09269 |

A. CLASSIFICATION OF SUBJECT MATTER
    Int.Cl⁷   H01L21/02

According to International Patent Classification (IPC) or to both national classification and IPC

B. FIELDS SEARCHED

Minimum documentation searched (classification system followed by classification symbols)
    Int.Cl⁷   H01L21/02

Documentation searched other than minimum documentation to the extent that such documents are included in the fields searched
    Jitsuyo Shinan Koho        1922-1996    Toroku Jitsuyo Shinan Koho   1994-2001
    Kokai Jitsuyo Shinan Koho  1971-2001    Jitsuyo Shinan Toroku Koho   1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2000-182917 A (Toshiba Corporation), 30 June, 2000 (30.06.00), Full text; Figs. 1 to 25   (Family: none) | 1-12 |
| X | JP 11-219874 A (Hitachi, Ltd.), 10 August, 1999 (10.08.99), Full text; Figs. 1 to 10   (Family: none) | 1-12 |
| A | JP 2000-252179 A (Hitachi, Ltd.), 14 September, 2000 (14.09.00), Full text; Figs. 1 to 15   (Family: none) | 1-12 |
| A | JP 11-267952 A (NEC Kyushu Ltd.), 05 October, 1999 (05.10.99), Full text; Figs. 1 to 9   (Family: none) | 1-12 |
| A | JP 11-260683 A (Sony Corporation), 24 September, 1999 (24.09.99), Full text; Figs. 1 to 4   (Family: none) | 1-12 |
| A | JP 11-186204 A (NEC Corporation), 09 July, 1999 (09.07.99), | 1-12 |

☒ Further documents are listed in the continuation of Box C.        ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 December, 2001 (10.12.01) | 18 December, 2001 (18.12.01) |

| Name and mailing address of the ISA/ | Authorized officer |
|---|---|
| Japanese Patent Office | |
| Facsimile No. | Telephone No. |

Form PCT/ISA/210 (second sheet) (July 1992)

16

**INTERNATIONAL SEARCH REPORT**

| International application No. |
| --- |
| PCT/JP01/09269 |

C (Continuation).   DOCUMENTS CONSIDERED TO BE RELEVANT

| Category* | Citation of document, with indication, where appropriate, of the relevant passages | Relevant to claim No. |
| --- | --- | --- |
| | Full text; Figs. 1 to 5   (Family: none) | |
| A | JP 10-280174 A (Matsushita Electric Ind. Co., Ltd.), 20 October, 1998 (20.10.98), Full text; Figs. 1 to 8   (Family: none) | 1-12 |
| A | JP 5-13291 A (Fujitsu Limited), 22 January, 1993 (22.01.93), Full text; Figs. 1 to 4   (Family: none) | 1-12 |

Form PCT/ISA/210 (continuation of second sheet) (July 1992)